Europäisches Patentamt

European Patent Office

Office européen des brevets

(19)

(11) Veröffentlichungsnummer : **0 035 093**
**B1**

# (12) EUROPÄISCHE PATENTSCHRIFT

(45) Veröffentlichungstag der Patentschrift :
27.07.88

(21) Anmeldenummer : 81100089.2

(22) Anmeldetag : 08.01.81

(51) Int. Cl.⁴ : **H 01 L 23/54**, H 01 L 23/14,
H 01 L 23/56

(54) Anordnung zum Packen mehrerer schnellschaltender Halbleiterchips.

(30) Priorität : 25.01.80 US 115580

(43) Veröffentlichungstag der Anmeldung :
09.09.81 Patentblatt 81/36

(45) Bekanntmachung des Hinweises auf die Patenterteilung : 27.07.88 Patentblatt 88/30

(84) Benannte Vertragsstaaten :
DE FR GB IT

(56) Entgegenhaltungen :
US-A- 3 680 005
ELECTRONIC DESIGN, Band 28, Nr. 1, 7. Januar 1980,
Seiten 39-40, St. Rochelle Park, US "Multilayered
ceramic packages multiply circuit densities 40 times"
IBM TECHNICAL DISCLOSURE BULLETIN, Band 22,
Nr. 8A, Januar 1980, Seiten 3406-3409 C.W. HO et al.:
"Fabrication of multiple LSI silicon chip modules"
IBM TECHNICAL DISCLOSURE BULLETIN, Band 21,
Nr. 5, Oktober 1978, Seiten 1895-1897 S. MAGDO:
"Low inductance module"
IBM TECHNICAL DISCLOSURE BULLETIN, Band 20,
Nr. 6, November 1977, Seiten 2221-2222 J.A. BENENA-
TI: "Semiconductor module"
IBM TECHNICAL DISCLOSURE BULLETIN, Band 19,
Nr. 4, September 1976, Seite 1188 O.R. ABOLAFIA et
al.: "Forming decoupling capacitors on a substrate"
ELECTRONICS INTERNATIONAL, Band 51, Nr. 20,
September 1978, Seiten 117-125, New York, US J.
LYMAN: "Packaging technology responds to the
demand for higher densities"
IBM TECHNICAL DISCLOSURE BULLETIN, Band 19,
Nr. 8, Januar 1977, Seiten 3046-3047 J. PARISI:
"Decoupling capacitor placement"

(73) Patentinhaber : International Business Machines Corporation
Old Orchard Road
Armonk, N.Y. 10504 (US)

(72) Erfinder : Barbour, Donald Ross
RD 2, Didell Road
Poughkeepsie N.Y. 12603 (US)
Erfinder : Lemke, Guido Albert
East Hook Road
Hopewell Junction N.Y. 12533 (US)
Erfinder : Magdo, Steven
Frances Drive
Hopewell Junction N.Y. 12533 (US)

(74) Vertreter : Neuland, Johannes, Dipl.-Ing.
IBM Deutschland GmbH Schönaicher Strasse 220
D-7030 Böblingen (DE)

**Beschreibung**

Die Erfindung bezieht sich auf eine Anordnung zum Packen mehrerer schnellschaltender Halbleiterchips, die ein mehrschichtiges dielektrisches Substrat mit einem fächerförmigen Signal-Verdrahtungsmuster und einer internen Metallisierung für das Verbinden der auf der oberen Fläche des Substrates angeordneten Halbleiterchips enthält und Mittel zum Zuführen externer Signale sowie der Stromversorgung.

Bei dem Trend der Halbleitertechnologie, Halbleiterchips mit stets zunehmender Mikrominiaturisierung herzustellen und mehr Bauelemente auf einem einzigen Halbleiterchip unterzubringen, besteht das dringende Bedürfnis nach einer kompatiblen Anordnung für das Aufnehmen der Halbleiterchips. Kompatibilität ist erwünscht, um die Vorteile niedrigerer Kosten, höherer Geschwindigkeiten und größerer Effektivität beizubehalten, die durch die Mikrominiaturisierung der Halbleiterchips erhalten werden.

Mit dem Fortschreiten der Technologie der integrierten Halbleiterschaltungen zu ständig wachsender Großintegration und zu Schaltkreisen mit höherer Schaltgeschwindigkeit ist es notwendig, eine Packung zur elektrischen Verbindung vorzusehen, die kompatibel ist mit den Leistungsanforderungen der zugeordneten Technologie der Halbleiterchips. Daher werden die Probleme der Signalverzögerung, der Impedanz der Packungsanordnung und des Übersprechens äußerst kritisch. Die Technologie der Übertragungsleitungen muß bei den Anordnungen zum Packen von Halbleiterschaltungen berücksichtigt werden, um die äußerst hohen Schaltgeschwindigkeiten auszunutzen.

Laminierte mehrschichtige und mit interner Verdrahtung versehene Grundkarten zur Aufnahme von Halbleiterchips sind bekannt und in dem US-Patent 3 564 114 dargestellt und beschrieben. Mehrlagige keramische Substrate, zur Aufnahme und Verbindung einer Reihe von Halbleiterchips sind ebenfalls bekannt, wie aus dem Artikel « A Fabrication Technique for Multi-Layer Ceramic Modules » von H.D. Kaiser in der Zeitschrift « Solid State Technology, Mai 1972, Seiten 35 bis 40 hervorgeht. Bei dieser Technologie werden ungebrannte Blätter aus Keramik, d. h. aus einem Keramikpulver, das durch temporäre organische Bindemittel in Blattform zusammengehalten wird, metallisiert mit Edelmetallen oder hochschmelzenden Metallen, gewöhnlich mittels Siebdruck. Die metallisierten Blätter werden gestapelt, laminiert und gebrannt, um ein monolithisches keramisches Substrat zu bilden. Diese Technologie bietet eine Gelegenheit zur dreidimensionalen Verdrahtung innerhalb des früher vergeudeten oder unzugänglichen Raumes in einem keramischen Substrat. Die Benutzung dieses vergeudeten Raumes resultiert in der Schaffung einer widerstandsfähigen Anordnung zum hochdichten Packen elektronischer Schaltungen bei guter Leistung und Zuverlässigkeit. Mit dem Aufkommen mikrominiaturisierter und hochintegrierter Halbleiterschaltungen und den damit einhergehenden höheren Arbeitsgeschwindigkeiten wurde die Kompatibilität des Substrates und der von ihm getragenen Halbleiterchips äußerst wichtig. Um die Betriebseigenschaften des Substrates zu beeinflussen und vorherzusagen, wie z. B. Signalverzögerung, Übersprechen, usw. wird es zunehmend wichtiger, die Impedanz- und Kapazitätseigenschaften der internen Verdrahtung zu beeinflussen als auch deren Länge. Die zunehmende Dichte der Halbleiterschaltungen auf dem Substrat erzwingt auch sehr große Anforderungen an die Kühlung, um die Temperatur der Halbleiterchips während des Betriebes im sicheren Betriebsbereich aufrechtzuerhalten.

Die in den Patentansprüchen gekennzeichnete Erfindung löst die Aufgabe, eine verbesserte Anordnung zum Packen schnellschaltender Halbleiterchips zu schaffen, bei der die an die Impedanz und Kapazität der internen Verdrahtung des Substrates für die Halbleiterchips weitgehend berücksichtigt wurden und auch eine gute Kühlung der Halbleiterchips gewährleistet ist.

Im folgenden wird die Erfindung anhand der Beschreibung zweier Ausführungsbeispiele in Verbindung mit den Zeichnungen näher erläutert.

Es zeigt :

Fig. 1 eine perspektivische, teilweise geschnittene Ansicht der Anordnung und internen Struktur eines ersten bevorzugten Ausführungsbeispiels der Erfindung ;

Fig. 2 eine Draufsicht auf ein Zwischenelement, das eines der Elemente des ersten Ausführungsbeispieles der Erfindung ist ;

Fig. 3 eine perspektivische teilweise geschnittene Darstellung der Unterseite eines Zwischenelementes ;

Fig. 4 eine perspektivische, teilweise geschnittene Ansicht, die die Verbindung zwischen benachbarten Zwischenelementen zeigt, die auf einem Substrat befestigt sind ;

Fig. 5 eine vergrößerte Draufsicht, die das fächerformige Metallisierungsmuster auf dem Zwischenelement darstellt ;

Fig. 6 eine Schnittansicht von vorn eines zweiten bevorzugten Ausführungsbeispieles der Packungsanordnung nach der Erfindung ;

Fig. 7 eine perspektivische Ansicht des Substrats des zweiten bevorzugten Ausführungsbeispieles der Erfindung.

Mit dem Fortschreiten der Technologie der integrierten Halbleiterschaltungen zu immer höherer Integration und immer schnellerschaltenden Schaltkreisen wächst auch die Anzahl der Treiberschaltungen auf einem Halbleiterchip, die gleichzeitig schalten können. Dies stellt eine hohe Anforderung an das Stromversorgungssystem dar, das während kurzer Zeitintervalle hohe Einschaltströme liefern muß, ohne irgendein Störsignal, das als ΔI-Störsignal bezeichnet wird, in dem Stromverteilungssystem zu verursachen. Störsignale können sich in dem Stromverteilungssystem ausbreiten und ein unbeabsichtigtes Schalten verursachen, wenn sie gesperrte Treiberstufen erreichen.

Beispielsweise muß eine Treiberschaltung für ein das Halbleiterplättchen verlassendes Signal einen Strom von 20 mA in eine 50 Ω-Leitung schalten, um ein Signal von 1 V zu erzeugen. Die Stromversorgungsleitung für 50 gleichzeitig schaltende Treiberstufen muß sehr schnell einen Einschaltstrom von 1 A liefern. Daher sind von der Stromversorgungsleitung her gesehen die 50 Ω-Signalleitungen parallel geschaltet mit einer resultierenden Eingangsimpedanz von 1 Ω. Wenn die Eingangsimpedanz der Stromversorgungsleitung, von den Signalleitungen aus gesehen, 0,1 Ω beträgt, erzeugt der Einschaltstrom von 1 A eine Störspannung in den Stromversorgungsleitungen von 0,1 Ω × 1 A = 0,1 V. Diese Störspannung hat bezüglich der Signalspannung die entgegengesetzte Phase und verringert daher deren Amplitude. Dies zeigt die Wichtigkeit einer Stromversorgungsleitung mit einer sehr geringen Eingangsimpedanz.

Die ideale Lösung zur Verringerung der ΔI-Störspannung bestünde darin, die Leistung für die Halbleiterchips aus einem großen Entkoppelkondensator zu liefern, der direkt unter den Halbleiterchips angeordnet und ihnen allen gemeinsam ist. Die Stromzufuhr zu jedem Halbleiterchip erfolgt über vertikale Drähte. Man kann diese Art des Stromverteilungssystems als einen radialen Hohlleiter ansehen. Eine gute Zusammenfassung über radiale Hohlleiter findet sich in dem von N. Marcuvitz herausgegebenen « Waveguide Handbook » Dover Publishing, 1965 c 1951. Der Wellenwiderstand ist definiert als

$$Z_0 = \sqrt{\frac{L}{C}} \qquad\qquad (1)$$

wobei L die Induktivität und C die Kapazität ist.

Der Wellenwiderstand bei einem beliebigen Radius r des Rundhohlleiters ist :

$$Z_0 = \frac{\mu}{\varepsilon}\ \frac{b}{2\,\pi r} \qquad\qquad (2)$$

in der μ die Permeabilität, ε die Dielektrizitätskonstante und b der Abstand zwischen den Ebenen ist.

Da jedoch jeder Abschnitt mit einer Impedanz abgeschlossen ist, die kleiner als sein Wellenwiderstand ist, ist die tatsächliche Eingangsimpedanz $Z_{ein}$ beträchtlich geringer als der Wellenwiderstand bei diesem Radius.

$$Z_{ein} \cong Z_0 \left[ \frac{\pi K r}{2} + j\, K r \ln \frac{2}{1,78\,K r} \right] ; \quad K = 2\,\pi f\, \sqrt{\mu\varepsilon} \qquad\qquad (3)$$

in der f die Frequenz ist.

Beispielsweise ist für eine Frequenz von 160 MHz die Eingangsimpedanz für einen Impuls bei jedem Radius ungefähr 200 x kleiner als der Wellenwiderstand bei diesem Radius. Mit anderen Worten, wenn der radiale Hohlleiter mit einem Draht von 125 μ kontaktiert wird, sieht der Kontakt den Wellenwiderstand für einen Radius von 12,5 mm.

Die vorliegende Erfindung beschreibt zwei alternative Ausführungsbeispiele, die die Übersetzung der Eingangsimpedanz eines radialen Hohlleiters ausnutzen.

Das erste Ausführungsbeispiel mit einem großen Entkoppelkondensator, von dem die Energie verteilt wird, ist aus kleinen Kondensatoren aufgebaut, die aus Gründen der Ausbeute auf kleinen Zwischenelementen angeordnet sind. Diese Kondensatoren sind jedoch über Verbindungsleitungen mit niedrigerer Induktivität miteinander verbunden, um als ein allen Halbleiterchips gemeinsamer Kondensator zu wirken. Diese Zwischenelemente, die auch zur Verteilung der Signal- und Versorgungsspannungen dienen, sind auf einem mehrschichtigen Substrat befestigt, das für die Signalverbindungen zwischen den Zwischenelementen sorgt. Die Kondensatoren auf jedem Zwischenelement werden in Dünnfilmtechnologie hergestellt und daher stellt die Trennung zwischen den Kondensatoren dieser Art zusammen mit einer zusätzlichen Schicht zur Signalverteilung sowohl ein Verarbeitungs- als auch ein Ausbeuteproblem dar. Durch Unterteilen der Kondensatoren in kleine und durch ihr Anbringen auf den Zwischenelementen können beide Probleme gelöst werden. Das Verarbeiten der kleinen Zwischenelemente ist leichter und ihre Ausbeute ist höher, da jeder Kondensator einzeln getestet werden kann und nur die guten mit dem Substrat verbunden werden.

Es ist wichtig, daß der vertikale Abstand zwischen den Halbleiterchips und dem radialen Hohlleiter kleiner sein muß als 1,25 mm, da sonst die große Induktivität der Durchverbindung außerordentlich hohe ΔI-Störspannungen hervorruft.

Bei dem zweiten Ausführungsbeispiel ist ein großer Entkoppelkondensator oder radialer Hohlleiter

0 035 093

im Inneren des Substrates für den Modul oder die Grundkarte nahe bei deren Oberfläche aus einem Stück aufgebaut unter Verwendung der Dickfilmtechnologie. Der Abstand zwischen den Kondensatorebenen liegt im Bereich von 0,1 bis 0,2 mm und daher kann eine hohe Ausbeute erhalten werden. Die Eingangsimpedanz jedes Durchverbindungskontaktes für die Stromversorgung ($r \approx 6\ \mu$) ist jedoch verhältnismäßig hoch, über 0,23 $\Omega$ bei einem Abstand der Ebenen von 150 $\mu$. Die Eingangsimpedanz kann durch Anbringen kleiner Kondensatoren auf der Oberfläche des Substrates in der Nähe jedes Halbleiterchips verringert werden. Die resultierende Impedanz ergibt sich zu

$$Z_0 \cong \sqrt{\frac{L}{C + \Delta C}} \qquad (4)$$

wobei $\Delta C$ die Kapazität des zugefügten Kondensators pro Flächeneinheit darstellt.

Es ist jedoch wichtig, daß die Länge der Durchverbindung, die den zugefügten Kondensator mit dem radialen Hohlleiter verbindet, kleiner sein muß als ungefähr 1,2 mm und die Anzahl der Durchverbindungen pro Ebene für die Spannungszufuhr muß zumindest 2 betragen. Wenn die oben genannten Bedingungen nicht eingehalten werden, weist die Verbindung eine übermäßige Induktivität auf und die Näherung nach Gleichung (4) gilt nicht.

Es ist auch wichtig, wie bei dem ersten Ausführungsbeispiel, daß die Länge der Durchverbindung, die die Halbleiterchips und den radialen Hohlleiter verbindet, kleiner als 1,2 mm ist.

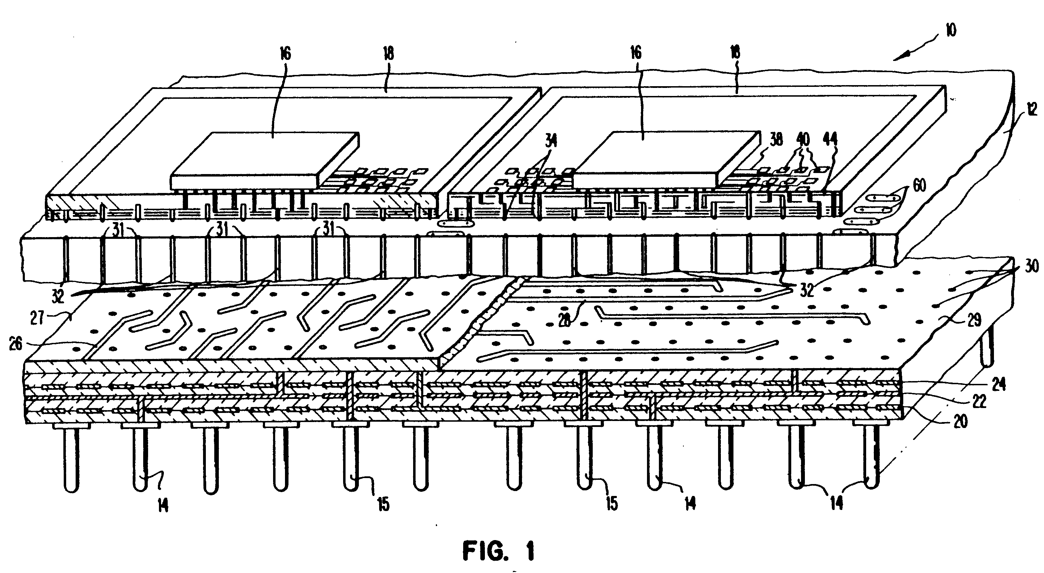

In Fig. 1 ist ein erstes Ausführungsbeispiel der Packungsanordnung zur Verbindung einer Reihe von integrierten Halbleiterchips dargestellt, das ein System zur Verteilung der Stromversorgung enthält, welches einen Aufbau aus radialen Hohlleitern besitzt mit parallelen Wellenleiterebenen mit einem niedrigeren Wellenwiderstand, die parallel zu den Halbleiterchips angeordnet sind. Die Packungsanordnung 10 für Halbleiterschaltungen weist ein mehrschichtiges keramisches Substrat 12 auf mit einer internen Verdrahtung, die die zum Betrieb der Halbleiterschaltungen erforderliche Leistung von den Eingangs-/Ausgangsstiften 14 den Halbleiterchips 16 zuführt, die auf den Zwischenelementen 18 befestigt sind, die wiederum auf der oberen Fläche des Substrates 12 angebracht sind. Das mehrschichtige keramische Substrat 12 schließt auch eine interne Verdrahtung zur Weiterleitung von Eingangs- und Ausgangssignalen von den Eingabe-/Ausgabestiften 14 zu dem Zwischenelement 18 und auch zwischen den auf dem Substrat 12 befestigten Zwischenelementen ein. Das dielektrische Material des Substrates kann ein polymerisiertes organisches Harzmaterial sein. In dem Substrat 12 sind eine Reihe von Ebenen 20, 22 und 24 zur Stromversorgung enthalten, die mit den Stiften 14 verbunden sind, an die die zum Betrieb der Halbleiterschaltung erforderlichen Spannungen angelegt werden. Die Ebenen 20, 22 und 24 für die Stromversorgung sind verhältnismäßig feste leitende Ebenen mit Ausnahme der Öffnungen, die es erlauben, daß sich Durchverbindungen durch die Ebenen erstrecken. Die Signalleitungen in dem Substrat sind paarweise auf benachbarten Ebenen angeordnet, wie das am klarsten aus Fig. 1 hervorgeht. Signalleitungen 26, die in der X-Richtung verlaufen, befinden sich alle in einer Ebene 27, wogegen Signalleitungen 28, die in der Y-Richtung verlaufen, sich auf der Ebene 29 befinden. Jedes X-Y-Ebenenpaar befindet sich zwischen zwei nicht dargestellten Ebenen mit einem Maschennetz für die Stromversorgung. Diese Netzmaschenebenen bestehen aus parallelen Leiterzügen sowohl in der X- als auch in der Y-Richtung, die über den Signalleitungen liegen und sind gegenüber den Stellen für Durchverbindungen versetzt.

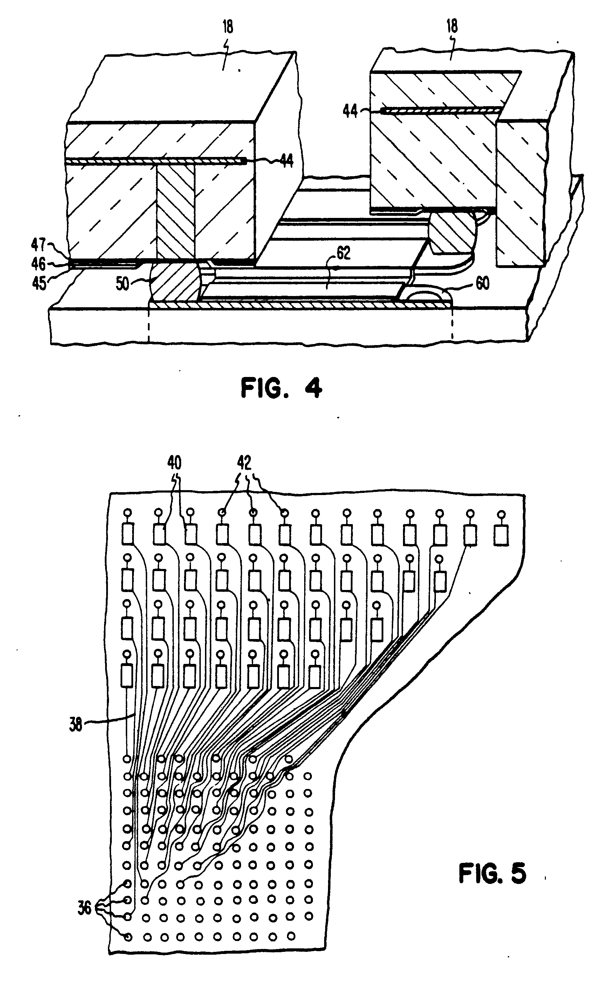

Die identischen Ebenen mit Netzmaschen für die Stromversorgung sind miteinander über Durchverbindungen verbunden und dienen als Abschirmungen für die Signalleitungen. Die Ebenen mit Netzmaschen sind auch mit den Wellenleiterebenen über Durchverbindungen verbunden. Dies stabilisiert die Spannung der Ebenen mit den Netzmaschen, die durch Rückströme verursacht wird, und verringert daher die Störspannungen. Durchverbindungen 30 sorgen für elektrischen Kontakt zwischen den verschiedenen Ebenen in dem Substrat 12. Lötanschlußflächen 32 sind auf der oberen Fläche des Substrates 12 über den Enden der Durchverbindungen aus dem Inneren des Substrates angeordnet. Die Lötanschlußflächen 32 sorgen für elektrische Verbindungen zu den Ebenen 20, 22 und 24 für die Stromversorgung, die mit den Stiften 14 verbunden sind. Lötflächen 31 sorgen für die elektrische Verbindung von den internen Metallisierungssystemen innerhalb des Substrates, die ihrerseits mit Stiften 15 verbunden sind, mit den Durchverbindungen für die Eingangs- und Ausgangssignale. Die tatsächliche Anzahl der Verdrahtungsebenen und der Ebenen zur Stromversorgung in dem Substrat kann, abhängig von den Forderungen, die durch die Anzahl von Halbleiterchips auferlegt werden, die untereinander verbunden sind, variieren. Wie schon erwähnt, sind die Zwischenelemente 18 auf der oberen Fläche des Substrates 12 befestigt und mit dem Substrat über Lötverbindungen 34 verbunden, die mit den Lötflächen 32 auf dem Substrat in Verbindung stehen. Jedes Zwischenelement hat auf seiner oberen Fläche eine Metallisierung, die aus einer Menge von Lötanschlußflächen 36 besteht, die mit einer Reihe von fächerförmig verlaufenden Metallisierungsleitungen 38 verbunden sind, die ihrerseits mit Anschlußflächen 40 für Schaltungsänderungen verbunden sind, die an den Durchverbindungen 42 enden, die nur in Fig. 5 dargestellt sind. Das Metallisierungssystem der oberen Fläche ist am besten in Fig. 5 dargestellt. Das Metallisierungsmuster auf der oberen Fläche der Zwischenelemente 18 kann in irgendeiner geeigneten Weise erzeugt werden, vorzugsweise durch Aufdampfen einer Metallschicht auf die obere

4

Fläche des Zwischenelementes, Abscheiden einer Schicht eines Photolackes über dem Metall, Belichten des Photolackes entsprechend einem gewünschten Muster, Entwickeln des Photolacks, um das gewünschte Muster zu definieren und nachfolgendes Abätzen des freigelegten Metalls mit einem geeigneten Ätzmittel. Es sei bemerkt, daß photolithographische Verfahren zur Bildung des Metallisierungsmusters auf dem Zwischenelement benutzt werden können, wogegen das gleiche Verfahren nicht sehr zweckdienlich benutzt werden kann, um ein Muster auf dem Substrat 12 zu bilden, wenn dort eines erwünscht ist. Das keramische Material schrumpft während des Sinterns sowohl in dem Substrat 12 als auch in dem Zwischenelement. Das Schrumpfen erfolgt im allgemeinen nicht völlig gleichförmig über alle Bereiche des Zwischenelementes oder Substrates. Da jedoch die Fläche des Zwischenelementes viel kleiner als die des Substrates ist, kann eine Übereinstimmung des Musters mit den Durchverbindungen in einem kleineren Bereich des Zwischenelementes erreicht werden. Direkt darunter und in enger Beziehung dazu ist eine feste Ebene 44 angeordnet, die in dem Zwischenelement an eine geeignete Spannung, üblicherweise das Erdopotential, angeschlossen ist. Die Ebene 44 ist massiv mit Ausnahme der Öffnungen, durch welche die verschiedenen Durchverbindungen sich erstrecken. Die Ebene 44 verringert die Kopplung der dicht benachbarten fächerförmig verlaufenden Leitungen 38 des Metallisierungsmusters auf der Oberfläche.

Die Ebenen mit radialen Hohlleitern werden auch dazu benutzt, die Durchverbindungen für die Stromversorgung aufzufächern. Die Durchverbindungen für die Stromversorgung, die vom Halbleiterchip kommen, sind innerhalb der Fläche des Halbleiterchips konzentriert. Wie das Fig. 1 zeigt, sind die meisten dieser Durchverbindungen für die Stromversorgung an den Wellenleiter-Ebenen unterbrochen und werden zu anderen Stellen außerhalb des Halbleiterchips geführt. Dadurch wird für ein wirksames Mischen von Durchverbindungen für die Stromversorgung und die Signalleitungen und auch die Stifte gesorgt, wodurch die Induktivität der Verbindungen für die Stromversorgung außerhalb des Moduls verringert wird.

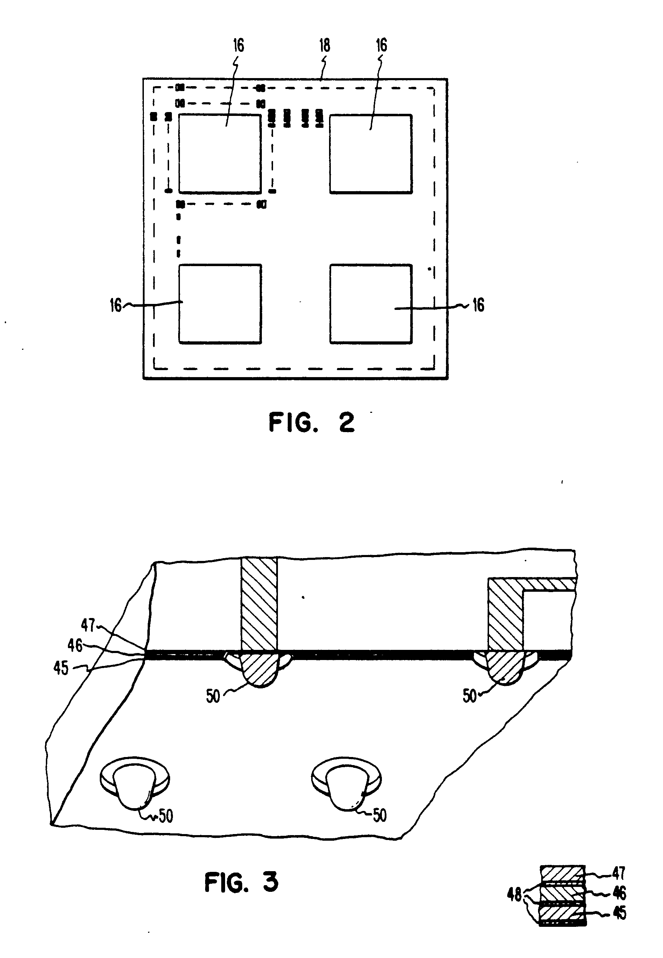

In Fig. 3 ist eine Reihe von Wellenleiter-Ebenen auf der Unterseite des Zwischenelementes 18 vorgesehen. Die Ebenen 45, 46 und 47 werden aus im wesentlichen festen Metallschichten gebildet, üblicherweise aus Aluminium oder Tantal, das auf die Unterseite des Zwischenelementes durch irgendein Verfahren aufgebracht wird. Die Metallschichten können durch Aufdampfen, Galvanisieren oder Siebdruck aufgebracht werden. Die Schichten 44, 46 und 47 sind voneinander getrennt und elektrisch voneinander isoliert durch dielektrische Schichten 48, die vorzugsweise durch Oxidieren des Metalls der benachbarten Wellenleiter-Ebene gebildet werden. Die Anordnung der Wellenleiter-Ebenen ist auch in Fig. 4 dargestellt. Jede der Wellenleiter-Ebenen 45, 46 und 47 sind mit Lötanschlußflächen 50 verbunden, die wiederum über Durchverbindungen verbunden sind, die sich durch das Substrat 12 bis zu den Ebenen 20, 22 und 24 für die Stromversorgung erstrecken. Wie das in Fig. 3 dargestellt ist, machen die Lötanschlußflächen 50 getrennten Kontakt zu jeder der Wellenleiter-Ebenen. In dem Bereich, der die Lötanschlußfläche, die mit dem Wellenleiter verbunden ist, umgibt, erstreckt sich die vorher ausgewählte Wellenleiter-Ebene nach innen auf die Lötanschlußfläche 50. Wie Fig. 3 zeigt, steht die Lötanschlußfläche 50 in elektrischem Kontakt mit der Wellenleiter-Ebene 45. Die Wellenleiter-Ebenen dienen auch zusammen als ein Entkoppelkondensator, der in der Nähe der Halbleiterschaltungen angeordnet ist. Die sich ergebenden Wellenleiter-Ebenen bilden ein System zur Verteilung der Stromversorgung, das verhältnismäßig billig herzustellen ist, sehr wirksam ist dadurch, daß es sehr dicht bei den Halbleiterschaltungen angeordnet ist und das durch Benutzen einer gut bekannten Technologie hergestellt werden kann. Zusätzliche Wellenleiter-Ebenen können, wenn das aufgrund der besonderen Anwendung erforderlich ist, vorgesehen werden. Wie das in Fig. 2 gezeigt ist, kann das Zwischenelement 18 mehr als ein Halbleiterchip aufweisen. Auf dem in Fig. 2 dargestellten Zwischenelement 18 sind 4 Halbleiterchips 16 befestigt und über die Metallisierung im Inneren des Zwischenelementes miteinander verbunden.

Wie das in Fig. 4 dargestellt ist, sind alle die einander entsprechenden Wellenleiter-Ebenen in jedem der Zwischenelemente unter Verwendung der in Fig. 4 dargestellten Struktur miteinander verbunden. Metallisierungsstreifen 60 sind auf der oberen Fläche des Substrates 12 vorgesehen. Ein dielektrisches Material 62 von geringer Länge liegt über dem mittleren Teil des Streifens 60 und bildet einen Damm für das Lötmaterial beim Lötvorgang. Die mit einer Wellenleiter-Ebene verbundene Anschlußfläche 50 ist mit einer gleichen Wellenleiter-Ebene in dem benachbarten Zwischenelement über den Metallisierungsstreifen 60 verbunden, der auch mit einer gleichen Lötanschlußfläche auf dem benachbarten Zwischenelement verbunden ist.

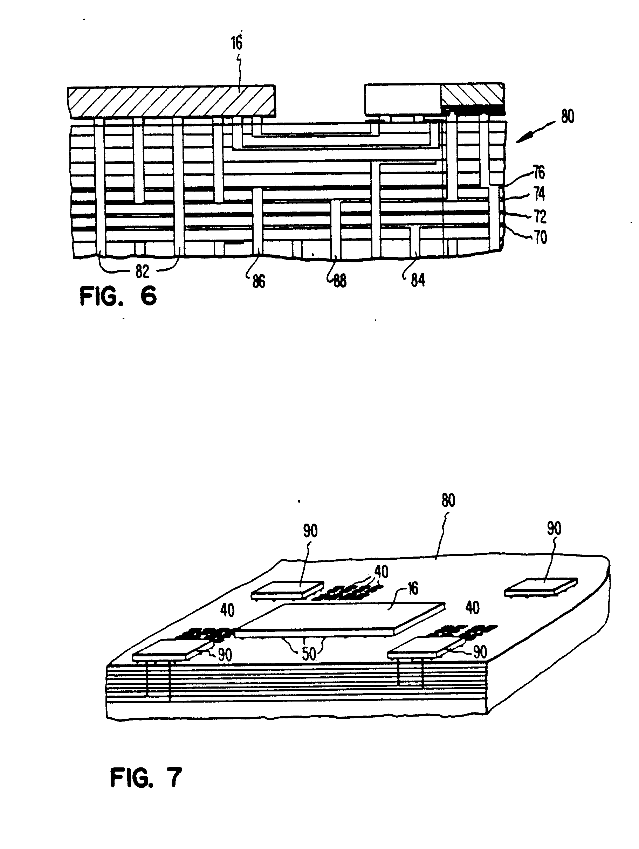

Ein zweites Ausführungsbeispiel der Packungsanordnung nach der Erfindung, welches ein Verteilungssystem für die Stromversorgung enthält, einschließlich einer radialen Hohlleiter-Struktur mit radialen Hohlleiter-Ebenen mit geringem Wellenwiderstand ist in den Fig. 6 und 7 dargestellt. Bei dem Ausführungsbeispiel nach Fig. 6 befinden sich die Wellenleiter-Ebenen 70, 72, 74 und 76 in einem mehrschichtigen keramischen Substrat 80. Die Wellenleiter-Ebenen sind mit einer nicht dargestellten Ebene für die Stromversorgung in dem unteren Teil des Substrates 80 über die Durchverbindungen 82, 84, 86 und 88 verbunden. Die Halbleiterchips 16 sind direkt auf der Oberfläche des Substrates 80 befestigt, vorzugsweise durch Lötverbindungen. Anschlußflächen 40 für Schaltungsänderungen sind auf der Oberfläche vorgesehen, die ihrerseits mit den Lötanschlußflächen 50 des Halbleiterchips 16 verbunden sind. Die Verbindung zwischen den Anschlußflächen 40 für Schaltungsänderungen und den Lötverbindungen werden mittels interner Verdrahtungsmuster in dem Substrat 80 gemacht. Durchverbindungen für die Stromversorgung erstrecken sich aufwärts von den Wellenleiter-Ebenen 70, 72, 74 und 76 zu den Stromversorgungsanschlüssen des Halbleiterchips 16, wie das in Fig. 6 dargestellt ist. Auf der Oberfläche des Substrates 80 sind auch eine Reihe von Entkoppelkondensatoren 90 vorgesehen, die vorzugsweise in diagonaler Richtung weg von den Ecken des Halbleiterchips 16 angeordnet sind. Diese Lage der Entkoppelkondensatoren ist erwünscht, da weniger Störungen mit dem fächerartigen Metallisierungsmuster auftreten, das die Anschlußflächen mit den Anschlußflächen für Schaltungsänderungen verbindet. Jeder der Entkoppelkondensatoren 90 besitzt eine Reihe von leitenden Schichten, die durch eine dielektrische Schicht getrennt sind. Der Entkoppelkondensator kann gebildet werden durch Abscheiden einer Lage eines geeigneten Metalles wie Aluminium oder Tantal, Oxidieren des Metalles zur Bildung einer dielektrischen Schicht und nachfolgendes Abscheiden einer anderen Metallschicht. Lötverbindungen mit jeder der leitenden Schichten des Kondensators werden im allgemeinen in der gleichen Weise hergestellt, die in Verbindung mit den Wellenleiter-Ebenen auf der Unterseite der Zwischenelemente 18 beschrieben wurde, wie das in Fig. 4 dargestellt ist. Jede Schicht in dem Entkoppelkondensator 90 ist mit einer Wellenleiter-Ebene 70, 72, 74 oder 76 verbunden, wie das in Fig. 6 dargestellt ist. Die Kombination der Entkoppelkondensatoren 90 und der festen Wellenleiterebenen 70, 72, 74 und 76 resultiert in einer Eingangsimpedanz von weniger als 0,2 Ω. Die Entkoppelkondensatoren 90 sind bei diesem Ausführungsbeispiel notwendig, da die Wellenleiter-Ebenen 70 bis 76 einen Abstand aufweisen, der von der Dicke der ungebrannten keramischen Blätter bestimmt wird, die zur Bildung des Substrates benutzt werden. Im Gegensatz dazu sind bei dem in den Fign. 1 bis 5 dargestellten Ausführungsbeispiel die Wellenleiter-Ebenen an der Unterseite der Zwischenelemente dicht benachbart, d. h. nur durch die Dicke der oxidierten oder eloxierten Schicht der Ebene getrennt. Bei der Herstellung der Ausführungsbeispiele nach der Erfindung ist es erwünscht, daß die Durchverbindungen für die Stromversorgung und für die Signalleitungen innerhalb des Substrates so gleichförmig wie möglich verteilt werden. Dies verringert die Induktivität der außerhalb des Halbleiterchips verlaufenden Verbindung für die Stromversorgung. Dies verringert die $\Delta I$-Störspannungen, die durch das gleichzeitige Schalten von Treiberstufen verursacht werden.

**Patentansprüche**

1. Anordnung zum Packen mehrerer schnellschaltender Halbleiterchips, die ein mehrschichtiges dielektrisches Substrat mit einem an dessen oberer Fläche verlaufenden fächerförmigen Signal-Verdrahtungsmuster und einer internen Metallisierung für das Verbinden der auf der oberen Fläche des Substrates angeordneten Halbleiterchips enthält und Mittel zum Zuführen externer Signale sowie der Stromversorgung, dadurch gekennzeichnet, daß ein Verteilungssystem für die Stromversorgung der Halbleiterchips (16 ; Fig. 1) vorgesehen ist, das aus einer Struktur von radialen Hohlleitern mit parallelen Wellenleiter-Ebenen (45, 46, 47 ; Fig. 4) mit niedriger Eingangsimpedanz besteht, daß die Wellenleiter-Ebenen zwischen dem fächerförmigen Signal-Verdrahtungsmuster 38 ; Fig. 5) und der internen Metallisierung des Substrates (12 ; Fig. 1) angeordnet sind, daß vertikale Durchverbindungen für die Verbindung der Wellenleiter-Ebenen mit den Halbleiterchips und den Mitteln für externe Verbindungen vorgesehen sind und daß die Wellenleiter-Ebenen mit allen Halbleiterchips verbunden sind.

2. Anordnung nach Anspruch 1, dadurch gekennzeichnet, daß das dielektrische Material des Substrates ein keramisches Material ist.

3. Anordnung nach Anspruch 1, dadurch gekennzeichnet, daß das dielektrische Material des Substrates ein polymerisiertes organisches Harzmaterial ist.

4. Anordnung nach den Ansprüchen 1 bis 3, dadurch gekennzeichnet, daß die vertikalen Durchverbindungen (50 ; Fig. 3) für die Wellenleiter-Ebenen zwischen vertikalen Durchverbindungen für die Signal-Ebenen verteilt sind.

5. Anordnung nach den Ansprüchen 1 bis 4, dadurch gekennzeichnet, daß die Eingangsimpedanz des radialen Hohlleitern kleiner als 0,2 Ω ist.

6. Anordnung nach den Ansprüchen 1 bis 5, dadurch gekennzeichnet, daß der vertikale Abstand zwischen den Halbleiterchips auf der oberen Fläche des Substrates und den Wellenleiter-Ebenen kleiner als 1,5 mm ist.

7. Anordnung nach den Ansprüchen 1 bis 6, dadurch gekennzeichnet, daß das Substrat auch Stromversorgungs-Ebenen (22, 24, 26 ; Fig. 1), die zwischen Sätzen von X- und Y-Signal-Verdrahtungsebenen (27, 29) angeordnet sind, enthält sowie Durchverbindungen, die die Wellenleiter-Ebenen mit den Stromversorgungs-Ebenen verbinden.

8. Anordnung nach den Ansprüchen 1 bis 7, dadurch gekennzeichnet, daß das Substrat aus mehrschichtigen keramischen Zwischenelementen (18 ; Fig. 1) und einer Basis (12) besteht, daß die Zwischenelemente auf der Basis befestigt sind, daß jedes Zwischenelement zumindest eine Gruppe von Lötanschlußflächen (36 ; Fig. 5) auf der oberen Fläche enthält, daß zumindest ein Halbleiterchip auf der Gruppe von Lötanschlußflächen befestigt ist, daß ein Entkoppelkondensator auf der Unterseite vorgesehen ist, der aus einer Reihe von parallelen Wellenleiter-Ebenen besteht, und daß Durchverbindungen die Wellenleiter-Ebenen mit dem Anschluß für die Stromversorgung auf der Basis verbinden.

9. Anordnung nach den Ansprüchen 1 bis 8, dadurch gekennzeichnet, daß eine Reihe von Zwischenelementen vorgesehen ist und die parallelen Wellenleiter-Ebenen in den Zwischenelementen mit dem Anschluß für die Stromversorgung über Durchverbindungen und Lötanschlußflächen auf der Oberfläche der Basis verbunden sind.

10. Anordnung nach den Ansprüchen 1 bis 9, dadurch gekennzeichnet, daß eine Reihe von Halbleiterchips mit jedem Zwischenelement verbunden ist.

11. Anordnung nach den Ansprüchen 1 bis 10, dadurch gekennzeichnet, daß die Wellenleiter-Ebenen auf den Zwischenelementen aus im wesentlichen festen Schichten eines Metalls bestehen, das aus der aus Aluminium und Tantal bestehenden Gruppe ausgewählt wurde, daß die Wellenleiter-Ebenen voneinander durch eine dielektrische Schicht (48 ; Fig. 3) getrennt sind, die durch oxidiertes Metall der Wellenleiter-Ebenen gebildet ist.

12. Anordnung nach den Ansprüchen 1 bis 11, dadurch gekennzeichnet, daß das fächerförmige Metallisierungsmuster auf der oberen Fläche des Zwischenelementes mit der Gruppe von Lötanschlußflächen (36) verbunden ist und daß eine feste interne Leiterebene (44 ; Fig. 4) des Zwischenelementes in dichter Nachbarschaft zu dem fächerförmigen Metallisierungsmuster angeordnet ist.

13. Anordnung nach den Ansprüchen 1 bis 12, dadurch gekennzeichnet, daß Signal-Durchverbindungen zwischen den vertikalen Durchverbindungen für die Stromversorgung in der Basis des Substrates verteilt sind.

14. Anordnung nach den Ansprüchen 1 bis 13, dadurch gekennzeichnet, daß auf der oberen Fläche jedes Zwischenelementes auch Anschlußflächen (40 ; Fig. 1) für Schaltungsänderungen vorgesehen sind, einschließlich von Verbindungen auf der Oberfläche, die unterbrechbar sind und dem fächerförmigen Metallisierungsmuster zugeordnet sind.

15. Anordnung nach den Ansprüchen 1 bis 14, dadurch gekennzeichnet, daß die Wellenleiter-Ebenen Metallisierungsschichten sind, die in dem Substrat in dichter Nachbarschaft zur Oberfläche angeordnet sind, daß Durchverbindungen zur Stromversorgung der Halbleiterchips sich von den Wellenleiter-Ebenen zu ausgewählten Anschlußflächen einer Gruppe von Anschlußflächen auf dem Substrat erstrecken, daß diskrete Kondensatorelemente (90 ; Fig. 7) auf der oberen Fläche des Substrates befestigt sind und daß sich Durchverbindungen von den Wellenleiter-Ebenen zu den Kondensatorelementen erstrecken.

16. Anordnung nach den Ansprüchen 1 bis 15, dadurch gekennzeichnet, daß die Kondensatorelemente eine Reihe von Metallagen aufweisen, die den Wellenleiter-Ebenen entsprechen, und daß die Durchverbindungen für die Kondensatoren entsprechende Wellenleiter-Ebenen mit den entsprechenden Schichten in den Kondensatorelementen verbinden.

17. Anordnung nach den Ansprüchen 1 bis 16, dadurch gekennzeichnet, daß eine Reihe von Anschlußflächen für Schaltungsänderungen auf der Oberfläche des Substrates um jedes darauf befestigte Halbleiterchip herum angeordnet ist, daß die Anschlußflächen für Schaltungsänderungen mit der Gruppe von Lötanschlußflächen verbunden sind, daß die Kondensatorelemente in unmittelbarer Nachbarschaft der Halbleiterchips und diagonal zu deren Ecken angeordnet sind.

18. Anordnung nach den Ansprüchen 1 bis 17, dadurch gekennzeichnet, daß die elektrischen Verbindungen zwischen der Gruppe von Lötanschlußflächen und den Anschlußflächen für Schaltungsänderungen interne Metallisierungsleitungen in dem Substrat sind, die in der Nähe der oberen Fläche und über den Wellenleiter-Ebenen verlaufen.

19. Anordnung nach den Ansprüchen 1 bis 17, dadurch gekennzeichnet, daß die Metallschichten und die entsprechenden Wellenleiter-Ebenen über Durchverbindungen miteinander verbunden sind, die zwischen den Durchverbindungen für die Signalebenen angeordnet sind.

**Claims**

1. Arrangement for packing several fast switching semiconductor chips, comprising a multi-layered dielectric substrate with a fan-out signal wiring pattern on the substrate surface and an internal metallurgy for connecting the semiconductor chips on the substrate surface, and means for applying external signals and the power supply, characterized in that a distribution system for the power supply of the semiconductor chips (16 ; Fig. 1) is provided which consists of a structure of radial waveguides with parallel waveguide planes (45, 46, 47 ; Fig. 4) with a low input impedance, that the waveguide planes are located between the signal fan-out wiring pattern (38, Fig. 5) and the internal metallurgy of the substrate (12 ; Fig. 1), that vertical vias connecting the waveguide planes with the semiconductor chips and the means for external connections are provided, and that the waveguide planes are connected with all semiconductor chips.

2. Arrangement as claimed in claim 1, characterized in that the dielectric material of the substrate is a ceramic material.

3. Arrangement as claimed in claim 1, characterized in that the dielectric material of the substrate is a polymerized organic resin material.

4. Arrangement as claimed in any one of claims 1 to 3, characterized in that the vertical vias (50 ; Fig. 3) for the waveguide planes are distributed between vertical vias for the signal planes.

5. Arrangement as claimed in any one of claims 1 to 4, characterized in that the input impedance of the radial waveguides is less than 0.2 ohm.

6. Arrangement as claimed in any one of claims 1 to 5, characterized in that the vertical distance between the semiconductor chips on the substrate surface and the waveguide planes is less than 1.5 mm.

7. Arrangement as claimed in any one of claims 1 to 6, characterized in that the substrate further includes power planes (22, 24, 26 ; Fig. 1) arranged between sets of X and Y signal wiring planes (27, 29) as well as vias interconnecting the waveguide planes with the power planes.

8. Arrangement as claimed in any one of claims 1 to 7, characterized in that the substrate consists of multilayer ceramic interposers (18 ; Fig. 1) and a base (12), that the interposers are mounted on the base, that each interposer comprises at least one cluster of solder pads (36 ; Fig. 5) on the surface, that at least one semiconductor chip is mounted on the cluster of solder pads, that a decoupling capacitor is provided on the bottom side which consists of a series of parallel waveguide planes, and that vias interconnect the waveguide planes with the power connection on the base.

9. Arrangement as claimed in any one of claims 1 to 8, characterized in that a plurality of interposers are provided and the parallel waveguide planes in the interposers are interconnected with the power connection through vias and solder pads on the base surface.

10. Arrangement as claimed in any one of claims 1 to 9, characterized in that a plurality of semiconductor chips are connected to each of said interposers.

11. Arrangement as claimed in any one of claims 1 to 10, characterized in that the waveguide planes on the interposers are comprised of substantially solid layers of a metal selected from the group consisting of aluminum and tantalum, and that the waveguide planes are separated by a dielectric layer (48 ; Fig. 3) formed of oxidized metal of the waveguide planes.

12. Arrangement as claimed in any one of claims 1 to 11, characterized in that the fan-out metallurgy pattern on the upper surface of the interposer is connected to the cluster of solder pads (36), and that a solid internal conductor plane (44 ; Fig. 4) of the interposer is provided in close proximity to the fan-out metallurgy pattern.

13. Arrangement as claimed in any one of claims 1 to 12, characterized in that signal vias are interspersed between the vertical power vias in the substrate base.

14. Arrangement as claimed in any one of claims 1 to 13, characterized in that on the surface of each interposer engineering change pads (40 ; Fig. 1) are provided including surface deletable links associated with said fan-out metallurgy pattern.

15. Arrangement as claimed in any one of claims 1 to 14, characterized in that the waveguide planes are metallurgy layers disposed in the substrate in close proximity to the surface, that vias for the semiconductor chip power supply extend from the waveguide planes to selected pads of a cluster of pads of the upper substrate, that discrete capacitor elements (90 ; Fig. 7) are mounted on the substrate surface, and that vias extend from the waveguide planes to the capacitor elements.

16. Arrangement as claimed in any one of claims 1 to 15, characterized in that the capacitor elements have a plurality of metal layers corresponding to the waveguide planes, and that the vias from the capacitors connect corresponding waveguide planes with the corresponding layers in the capacitor elements.

17. Arrangement as claimed in any one of claims 1 to 16, characterized in that a plurality of engineering change pads are arranged on the substrate surface surrounding each semiconductor chip mounted thereon, that the engineering change pads are connected to the cluster of solder pads, and that the capacitor elements are arranged in close proximity to the semiconductor chips and in diagonal relation to the corners thereof.

18. Arrangement as claimed in any one of claims 1 to 17, characterized in that the electrical connections between the cluster of solder pads and the engineering change pads are internal metallurgy lines in the substrate extending adjacent the upper surface and above the waveguide planes.

19. Arrangement as claimed in any one of claims 1 to 18, characterized in that the metal layers and the corresponding waveguide planes are interconnected through vias that are interspersed with signal line vias.

## Revendications

1. Dispositif pour intégrer plusieurs microplaquettes à semiconducteurs à commutation rapide, qui contient un substrat diélectrique à couches multiples possédant un modèle de câblage de transmission de signaux en forme d'éventail, qui s'étend sur la surface supérieure du substrat, et une métallisation interne pour établir la liaison des microplaquettes à semiconducteurs situées sur la surface supérieure du substrat, et des moyens servant à amener des signaux extérieurs ainsi que l'alimentation en courant, caractérisé par le fait qu'il est prévu un système de répartition pour l'alimentation en courant des microplaquettes à semiconducteurs (16 ; figure 1), qui est constitué par une structure formée de guides d'ondes radiaux situés dans des plans parallèles (45, 46, 47 ; figure 4) de guides d'ondes et possédant une faible impédance d'entrée, que les plans des guides d'ondes sont disposés entre le modèle de câblage de signaux en éventail (38 ; figure 5) et la métallisation interne (12 ; figure 1), qu'il est prévu des connexions transversales verticales servant à relier les plans des guides d'ondes aux microplaquettes à semiconducteurs et aux moyens prévus pour des liaisons externes, et que les plans des guides d'ondes sont reliés à toutes les microplaquettes à semiconducteurs.

2. Dispositif selon la revendication 1, caractérisé en ce que le matériau diélectrique du substrat est un matériau céramique.

3. Dispositif selon la revendication 1, caractérisé en ce que le matériau diélectrique du substrat est un matériau formé d'une résine organique polymérisée.

4. Dispositif selon les revendications 1 à 3, caractérisé en ce que les connexions transversales verticales (50 ; figure 3) pour les plans des guides d'ondes sont réparties entre des connexions transversales verticales pour les plans de transmission de signaux.

5. Dispositif selon les revendications 1 à 4, caractérisé en ce que l'impédance d'entrée des guides d'ondes radiaux est inférieure à 0,2 Ω.

6. Dispositif selon les revendications 1 à 5, caractérisé en ce que la distance verticale entre les microplaquettes à semiconducteurs sur la face supérieure du substrat et les plans des guides d'ondes est inférieure à 1,5 mm.

7. Dispositif selon les revendications 1 à 6, caractérisé en ce que le substrat contient également des plans d'alimentation en courant (22, 24, 26 ; figure 1), qui sont disposés entre des ensembles de plans (27, 29) de câblage de transmission de signaux X ou Y, ainsi que des connexions transversales qui relient les plans des guides d'ondes aux plans d'alimentation en courant.

8. Dispositif selon les revendications 1 à 7, caractérisé en ce que le substrat est constitué par des éléments intercalaires céramiques (18 ; figure 1) à couches multiples et une base (12), que les éléments intercalaires sont fixés sur la base, que chaque élément intercalaire contient au moins un groupe de surfaces de raccordement soudables (36 ; figure 5) sur la surface supérieure, qu'au moins une microplaquette à semiconducteurs est fixée sur le groupe de surface de raccordement soudables, qu'il est prévu, sur la face inférieure, un condensateur de découplage constitué par une série de plans parallèles de guides d'ondes, et que des connexions transversales relient les plans des guides d'ondes à la borne d'alimentation en courant située sur la base.

9. Dispositif selon les revendications 1 à 8, caractérisé en ce qu'il est prévu une série d'éléments intercalaires, et que les plans parallèles des guides d'ondes sont reliés, dans les éléments intercalaires, à la borne d'alimentation en courant par l'intermédiaire de connexions transversales et des surfaces de raccordement soudables situées sur la surface supérieure de la base.

10. Dispositif selon les revendications 1 à 9, caractérisé en ce qu'une série de microplaquettes à semiconducteurs est reliée à chaque élément intercalaire.

11. Dispositif selon les revendications 1 à 10, caractérisé en ce que les plans des guides d'ondes sur les éléments intercalaires sont constitués par des couches sensiblement rigides d'un métal, qui a été sélectionné à partir du groupe constitué par l'aluminium et le tantale, et que les plans des guides d'ondes sont séparés les uns des autres par une couche diélectrique (48 ; figure 3), qui est formée par un métal oxydé des plans des guides d'ondes.

12. Dispositif selon les revendications 1 à 11, caractérisé en ce que le modèle de métallisation en forme d'éventail situé sur la surface supérieure des éléments intercalaires est relié au groupe de surfaces de raccordement soudables (36), et qu'un plan intérieur rigide de conducteurs (44 ; figure 4) de l'élément intercalaire est disposé au voisinage direct du modèle de métallisation en forme d'éventail.

13. Dispositif selon les revendications 1 à 12, caractérisé en ce que des connexions transversales de transmission de signaux sont réparties entre les connexions transversales verticales prévues pour l'alimentation en courant, dans la base du substrat.

14. Dispositif selon les revendications 1 à 13, caractérisé en ce qu'il est également prévu des surfaces de raccordement (40 ; figure 1) sur la surface supérieure de chaque élément intercalaire, pour des modifications de circuit, y compris des liaisons situées sur la surface et qui peuvent être rompues et sont associées au modèle de métallisation en forme d'éventail.

15. Dispositif selon les revendications 1 à 14, caractérisé en ce que les plans des guides d'ondes sont des couches de métallisation qui sont disposées dans le substrat au voisinage direct de la surface supérieure, que des connexions transversales utilisées pour l'alimentation en courant des microplaquettes à semiconducteurs s'étendent sur le substrat à partir des plans des guides d'ondes en direction de surfaces sélectionnées de raccordement d'un groupe de surfaces de raccordement, que des éléments de condensateurs discrets (90 ; figure 7) sont fixés sur la surface supérieure du substrat, et que des connexions transversales s'étendent depuis les plans des guides d'ondes jusqu'aux éléments de condensateurs.

16. Dispositif selon les revendications 1 à 15, caractérisé en ce que les éléments de condensateurs comportent une série de couches métalliques qui correspondent aux plans des guides d'ondes et que les connexions transversales pour les condensateurs relient des plans correspondants de guides d'ondes aux couches correspondantes dans les éléments de condensateurs.

17. Dispositif selon les revendications 1 à 17, caractérisé en ce qu'une série de surfaces de raccordement pour des modifications de circuits est disposée sur la surface supérieure du substrat autour de chaque microplaquette à semiconducteurs fixée sur ce substrat, que les surfaces de raccordement pour des modifications de circuit sont reliées au groupe de surfaces de raccordement soudables, que les éléments de condensateurs sont disposés au voisinage direct des plaquettes à

**0 035 093**

semiconducteurs et en diagonale par rapport à leurs angles.

18. Dispositif selon les revendications 1 à 17, caractérisé en ce que les liaisons électriques entre le groupe de surfaces de raccordement soudables et les surfaces de raccordement pour les modifications de circuit sont des lignes de métallisation internes ménagées dans le substrat et qui s'étendent à proximité de la surface supérieure et au-dessus des plans des guides d'ondes.

19. Dispositif selon les revendications 1 à 17, caractérisé en ce que les couches métalliques et les plans correspondants des guides d'ondes sont reliés entre eux par l'intermédiaire de connexions transversales qui sont disposées entre les connexions transversales prévues pour les plans de transmission de signaux.

FIG. 1

FIG. 2

FIG. 3

FIG. 4

FIG. 5

FIG. 6

FIG. 7